# FASCICULE DE BREVET EUROPEEN

(11) **EP 3 230 582 B1**
(45) Date de publication et mention de la délivrance du brevet: **09.01.2019**
(21) Numéro de dépôt: 15828344.0
(22) Date de dépôt: 30.11.2015
(51) Int. Cl.: F03B 13/18, H02N 2/18, H01L 41/113

(54) **APPAREIL POUR CONVERTIR UNE ÉNERGIE DE HOULE EN ÉNERGIE ÉLECTRIQUE**
VORRICHTUNG ZUR UMWANDLUNG VON WELLENENERGIE IN ELEKTRISCHE ENERGIE
APPARATUS FOR CONVERTING WAVE ENERGY INTO ELECTRICAL ENERGY

(30) Priorité: 01.12.2014 FR 1461694
(43) Date de publication de la demande: 18.10.2017
(73) Titulaire: Grosso, Gilles, 83140 Six-Fours-les-Plages (FR)
(72) Inventeur: Grosso, Gilles, 83140 Six-Fours-les-Plages (FR)
(74) Mandataire: Roman, Alexis
(86) Numéro de dépôt international: PCT/FR2015/053257
(87) Numéro de publication internationale: WO 2016/087757

(56) Documents cités:
- GB-A- 2 091 815
- US-A- 4 685 296
- US-A1- 2011 260 582
- US-A1- 2012 104 761
- US-B1- 6 194 815

## Description

### Domaine technique de l'invention.

L'invention a pour objet un appareil pour convertir une énergie de houle en énergie électrique.

Elle concerne le domaine technique de récupération de l'énergie de houle et sa transformation en une énergie exploitable, et plus précisément sa transformation en énergie électrique.

### État de la technique.

De nombreux documents décrivent l'utilisation des énergies marines et en particulier de l'énergie de la houle pour la production d'énergie électrique. Elle représente un réservoir considérable d'énergie et pourrait contribuer significativement au mix énergétique des nations bénéficiant d'un climat de houle propice si elle est exploitée efficacement. De plus, l'énergie de houle, généralement appelée énergie houlomotrice, apparait comme une des énergies naturelles renouvelables particulièrement intéressante pour trois aspects :
- sa densité moyenne est dix fois plus élevée que celle de l'énergie solaire et cinq fois plus élevée que celle de l'énergie éolienne,
- son caractère prédictible puisqu'elle peut être prévue 3 à 4 jours à l'avance contre quelques heures seulement pour l'énergie éolienne, sa disponibilité qui peut atteindre plus de 50% selon les systèmes.

Malgré ces nombreux avantages, cette énergie demeure très difficile à exploiter et peu de techniques proposées ont permis d'en effectuer une exploitation rentable et efficace.

Un très grand nombre de solutions techniques a été proposé jusqu'à présent. On recense actuellement plus de 100 projets (comme par exemple les documents US 7,355,293 (SEABASED AB) ou US 8,456,030 (OCEAN POWER TECHNOLOGIES INC.)) proposant des systèmes se composant généralement de trois parties :
- un système de conversion de l'énergie de la houle en une énergie mécaniquement exploitable, plus précisément un système permettant de convertir l'énergie cinétique d'une partie mobile excitée par la houle en une énergie mécaniquement exploitable. L'énergie générée se trouve sous des formes différentes selon le système proposé. Elle peut par exemple se trouver sous la forme d'une énergie hydraulique, d'une énergie pneumatique, cinétique ou encore potentielle ;
- un système de conversion de cette énergie mécanique en énergie électrique, encore appelé système d'extraction de puissance. Ce système va dépendre du type de conversion choisi dans le paragraphe précédent et peut se trouver sous des formes variées comme par exemple une turbine ou encore un générateur ;
- un système de transformation de l'énergie électrique permettant le raccordement au réseau et visant à lisser la production d'énergie (supercapacité, roue à inertie...).

Les nombreuses avaries enregistrées sur les différents projets de récupération de l'énergie de houle ont mis en avant la nécessité d'un certain nombre de règles de design :
- les systèmes doivent être petits de manière à limiter la prise à la mer et fournir une meilleure allocation du volume mobile,
- il est nécessaire de prévoir une stratégie de repli face aux tempêtes,
- il faut prendre en compte les contraintes liées à l'entretien et à la réparation du système.

Les principes physiques utilisés pour l'extraction de puissance utilisent généralement l'effet d'induction d'un alternateur électromagnétique. Si d'autres effets ont été proposés, peu ont été mis en oeuvre. On note l'utilisation de polymère piézoélectrique de type PVDF dont les rendements pressentis sont très faibles, ainsi que des développements utilisant les polymères electro-actifs (PEA).

Une étude (Thiam, A.G., Pierce, A.D. : Feasibility of using Piezoelectric in the conversion of océan wave energy - First Annual MREC Technology Conference) sur la densité de puissance extractible par une céramique piézoélectrique a été effectuée, et montre la nécessité d'un pompage fréquentiel pour l'utilisation de tels matériaux. L'effet piézoélectrique est aujourd'hui l'effet le plus couramment utilisé pour l'extraction de puissance des systèmes mécaniques vibrants. A ces échelles de vibration, ces matériaux couplés à des circuits non-linéaires dits « d'extraction de charge » permettent des gains de performance significatifs. Toutefois, très peu de concepts ont été proposés visant à l'utilisation de céramiques piézoélectriques à fort coefficient de couplage pour l'extraction de l'énergie de la houle.

On connaît plus particulièrement le document EP 2 284 386 (MAC TAGGART SCOTT LTD) qui propose un convertisseur permettant de transformer l'énergie cinétique des vagues en énergie électrique utilisable sur le réseau. Ce système comprend un élément flotteur se plaçant à la surface de l'eau ou dans l'eau et étant rattaché à un système d'extraction de puissance. Ce système ne possède aucun matériau piézoélectrique et se présente sous la forme d'un système hydraulique solidaire du fond de la mer. Bien que ce système permette de convertir l'énergie mécanique provenant de l'énergie cinétique de l'élément flotteur en énergie électrique, il n'est pas très performant et ne permet pas de produire de l'électricité en grande quantité. De plus, le système proposé est assez fragile et peut facilement être endommagé lors de tempêtes et donc lors de forte houle.

En particulier, les documents brevets US 4,685,296 (BURNS JOSEPH R) et US 2012/104761 (VAMVAS VASSILIOS) présentent un appareil pour convertir une énergie de houle en énergie électrique comprenant un élément flotteur avec lequel coopère un système d'extraction de puissance. Bien que les appareils proposés dans ces documents présentent des moteurs équipés de piliers piézoélectriques, leur performance reste très limitée et ne permet pas un rendement important d'énergie électrique.

L'invention vise à remédier à cet état des choses. En particulier, un objectif de l'invention est de proposer un appareil permettant d'extraire l'énergie de la houle de manière plus performante que les appareils connus de l'état de la technique.

Un autre objectif de l'invention est de fournir un appareil robuste, permettant de résister à une forte houle, comme par exemple lors d'une tempête.

### Divulgation de l'Invention.

La solution proposée par l'invention est un appareil pour convertir une énergie de houle en énergie électrique comprenant :
- un élément flotteur excité à une fréquence définie par la houle,
- un système d'extraction de puissance coopérant avec l'élément flotteur pour convertir une énergie mécanique en une énergie électrique, ladite énergie mécanique provenant du déplacement de l'élément flotteur excité par ladite houle.

Cette invention est remarquable en ce que ledit système d'extraction de puissance se présente sous la forme d'un amplificateur de fréquence se composant :
- d'au moins deux moteurs piézoélectriques chacun composé d'au moins un pilier piézoélectrique excité à une fréquence supérieure à celle dudit flotteur,
- d'un organe pour activer lesdits moteurs piézoélectriques, lequel organe agit sur les moteurs piézoélectriques de manière à écraser lesdits piliers piézoélectriques,
   chaque moteur piézoélectrique comprenant un dispositif d'amplification mécanique, lequel dispositif est relié à des galets et comporte :
   ∘ des mâchoires qui, lorsqu'elles sont sollicitées, appliquent une contrainte mécanique sur les piliers,
   ∘ un levier agissant sur les mâchoires de manière à les solliciter, lequel levier comporte une extrémité proximale rattachée auxdites mâchoires et une extrémité distale rattachée à un galet, ledit galet étant en contact avec l'organe de manière à activer ledit moteur piézoélectrique.

Elle est également remarquable en ce que ledit système d'extraction de puissance comporte un bras oscillant composé d'une première extrémité rattachée audit organe et d'une deuxième extrémité rattachée audit flotteur, de manière à ce que ledit bras transfère l'énergie mécanique provenant du déplacement dudit flotteur audit organe.

Cette configuration permet la fabrication d'un dispositif plus performant ayant un rendement énergétique plus important et étant plus robuste que les dispositifs existants. En effet, l'exploitation des propriétés piézoélectriques des céramiques permet d'améliorer le rendement de transformation de l'énergie de houle en énergie électrique.

D'autres caractéristiques avantageuses de l'invention sont listées ci-dessous. Chacune de ces caractéristiques peut être considérée seule ou en combinaison avec les caractéristiques remarquables définies ci-dessus, lesquelles caractéristiques remarquables peuvent faire l'objet, le cas échéant, d'une ou plusieurs demandes divisionnaires :
- le système d'extraction de puissance peut se composer d'une couronne moteur, laquelle couronne moteur comporte plusieurs moteurs adjacents placés et fixés en étoile sur un support circulaire, lesquels moteurs sont placés de sorte que les galets situés sur l'extrémité distale de leurs leviers, soient en contact avec l'organe, lesdits galets coopérant avec ledit organe de manière à transférer leur énergie mécanique audit levier,
- l'organe peut se présenter sous la forme d'une came circulaire ondulée sur laquelle les galets se déplacent,
- la came circulaire ondulée peut comporter 2N+1 bosses, avec N étant égal au nombre de moteurs,
- le système d'extraction de puissance peut se composer de plusieurs couronnes moteur alignées axialement les unes par rapport aux autres,
- les couronnes moteur peuvent être installées de manière à ce que chacune de leurs cames soit décalée angulairement,
- une boîte à pignons peut être placée entre l'organe et le bras oscillant de manière à augmenter la vitesse de rotation de la came,
- le pilier peut être composé d'une alternance de céramiques piézoélectriques et d'électrodes empilées axialement,
- le pilier peut être raccordé à un circuit électronique, lequel circuit est adapté pour augmenter la quantité d'énergie électrique produite par ledit pilier,
- le bras oscillant peut être un bras articulé,
- l'appareil peut comporter une interface mécanique de fixation lui permettant de se fixer à une structure tierce.

L'invention concerne aussi une installation pour convertir l'énergie de la houle en énergie électrique. Cette installation est remarquable en ce qu'elle est composée de plusieurs appareils, lesquels appareils sont installés sur une structure tierce. Cette structure tierce peut être une structure flottante ou une structure immergée installée sur un fond marin.

### Description des figures.

D'autres avantages et caractéristiques de l'invention apparaîtront mieux à la lecture de la description d'un mode de réalisation préféré qui va suivre, en référence aux dessins annexés, réalisés à titre d'exemples indicatifs et non limitatifs et sur lesquels :
- la figure 1 est une vue schématique, en coupe, d'un pilier utilisé dans un appareil selon l'invention,
- la figure 2 est une vue schématique du pilier de la figure 1 combiné à un circuit d'extraction de charge,
- la figure 3 est une vue schématique d'un moteur piézoélectrique comprenant des piliers de la figure 1 et un dispositif d'amplification mécanique,
- la figure 4a est une vue schématique d'une couronne moteur composée de moteurs piézoélectriques de la figure 3,
- la figure 4b est une vue schématique d'une came composant la couronne moteur de la figure 4a,
- la figure 5 est une vue schématique d'un assemblage de plusieurs couronnes moteurs,
- la figure 6a est une vue schématique d'un appareil selon l'invention,
- la figure 6b est une vue schématique d'un appareil selon l'invention, celui-ci étant composé d'un bras articulé,
- la figure 7a est une représentation schématique du système d'extraction de puissance utilisé dans l'appareil de l'invention,
- la figure 7b est une vue schématique en coupe du système de la figure 6a,
- la figure 8 est une vue schématique de l'appareil de la figure 4b incluant un carénage,
- la figure 9 est une vue schématique d'une installation de plusieurs appareils selon l'invention,
- la figure 10 est une vue schématique de l'appareil en position rabattue

### Modes préférés de réalisation de l'invention.

L'appareil proposé dans l'invention se présente sous la forme d'un élément flotteur rattaché à un système d'extraction de puissance, plus particulièrement un générateur piézoélectrique. Celui-ci est composé de plusieurs moteurs piézoélectriques assemblés et soumis à une contrainte mécanique dérivée de la houle. L'appareil comprend un élément flotteur excité par la houle et qui transfère son énergie cinétique à un bras oscillant. Ce bras permet de mettre en rotation un arbre placé à l'entrée du générateur piézoélectrique et ainsi de transférer l'énergie mécanique créée aux moteurs piézoélectriques qui vont par la suite la transformer en énergie électrique.

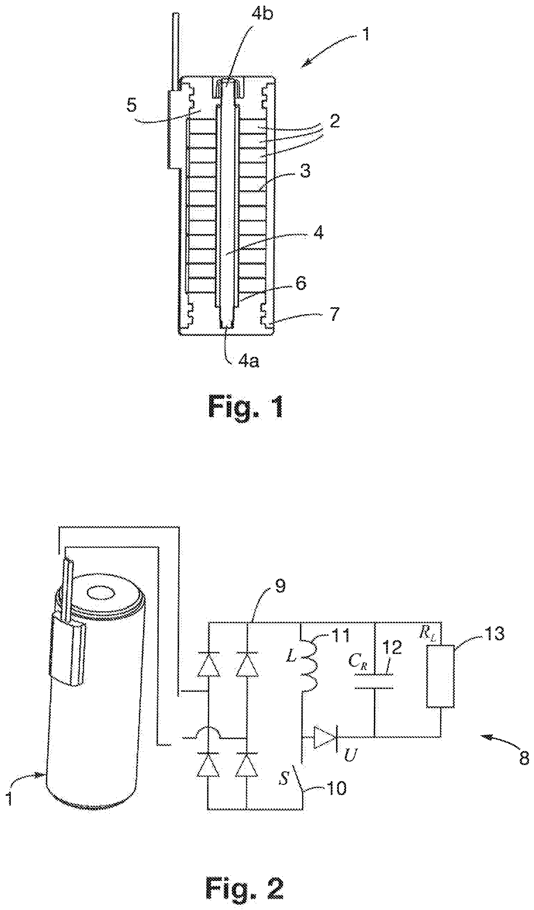

La figure 1 représente un pilier 1 constituant l'appareil selon l'invention. Il se compose d'un empilement de céramiques piézoélectriques **2** qui comprend préférentiellement entre deux et cinquante céramiques **2** mais peut en comprendre un plus grand nombre, comme par exemple 150. Ces céramiques **2** sont préférentiellement à section circulaire trouée, ont un diamètre pouvant varier de 1 cm à 20 cm, et une épaisseur comprise entre 1 mm et 100 mm. Les trous présents dans chaque céramique **2** sont effectués de manière à pouvoir les aligner. Lors de l'empilement, les céramiques **2** sont alternées avec des électrodes **3** de même section et de dimensions similaires. Celles-ci sont fabriquées dans un matériau conducteur, comme par exemple le cuivre ou le bronze.

Les trous présents au centre des céramiques **2** et des électrodes **3** permettent de former un trou central coaxial au pilier **1.** Ce trou central permet le passage d'une tige **4** permettant le centrage, l'alignement et le maintien des céramiques **2** et des électrodes **3.** Dans un mode de réalisation, la tige **4** possède des moyens de fixation **4a, 4b** situés sur chacune de ses extrémités et permettant de la maintenir dans une position donnée. Ces moyens de fixation **4a, 4b** peuvent par exemple, se trouver sous la forme de filetages permettant de visser des éléments de maintien **5.** Ces éléments **5** peuvent être des écrous, des boulons, ou encore toute autre forme convenant à l'Homme du métier.

Dans un mode de réalisation préféré, des pièces métalliques **5** sont placées sur chacune des extrémités de la tige **4** de manière à enserrer l'empilement d'électrodes **3** et de céramiques **2.** Ces pièces **5** sont préférentiellement en métal mais peuvent être réalisées dans un matériau rigide tel qu'un acier ou encore une céramique.

Les piliers **1** peuvent posséder des moyens d'isolation. Par exemple, la tige **4** peut être placée dans un fourreau **6** fabriqué dans un matériau isolant comme par exemple du bois, du caoutchouc, ou encore du polystyrène. Chaque pilier **1** peut aussi posséder une protection extérieure **7** permettant de l'isoler électriquement du reste de l'appareil et ainsi améliorer la sécurité lors de son usage.

Comme le montre la figure 2, le pilier **1** est raccordé à un circuit électronique **8** dit d'extraction de charges. Bien qu'un seul pilier **1** ne soit représenté, dans la pratique, il est possible qu'un circuit **8** soit connecté simultanément à plusieurs piliers **1.**

Ce circuit **8** récupère l'énergie électrique produite par les piliers piézoélectriques **1.** Il se compose préférentiellement d'un pont redresseur de tension **9,** d'un interrupteur haute tension **10** ainsi que d'une bobine **11** et d'une capacité de filtrage **12.** Tous ces composants, connus de l'Homme du métier, servent à maximiser l'énergie électrique produite par les piliers **1.** Ainsi le circuit **8** utilisé va permettre d'extraire le maximum d'énergie électrique produite par chacun des piliers **1.** Cette configuration permet de doubler l'énergie électrique récoltée en la récupérant une première fois lors de l'écrasement des piliers 1, et une deuxième fois lors de leur relâchement.

Dans un mode de réalisation, le circuit électronique **8** possède un système de stockage temporaire **13,** comme par exemple une batterie ou un banc de supercapacités. Ce système de stockage temporaire **13** permet ainsi de stocker l'électricité produite par les piliers **1** avant son conditionnement pour une utilisation sur le réseau.

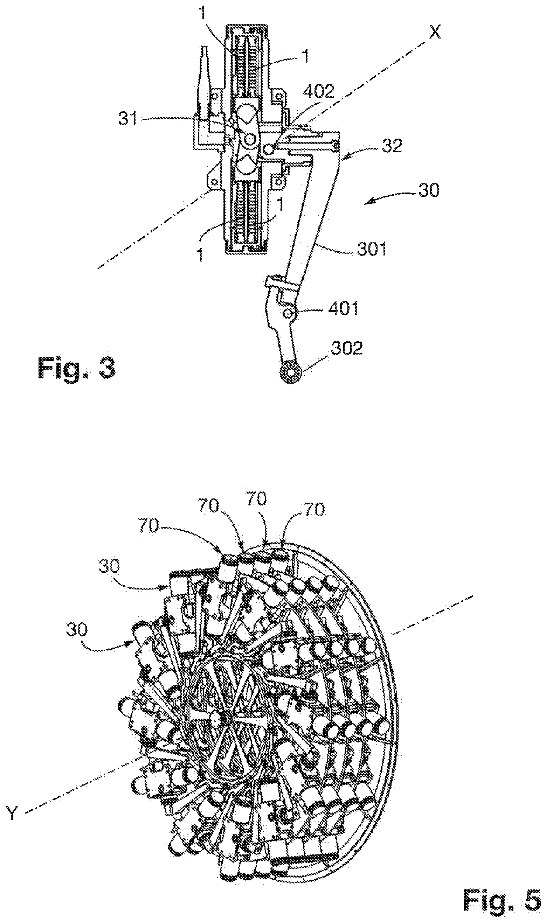

La figure 3 montre un moteur piézoélectrique **30** constituant l'appareil de l'invention. Celui-ci se compose de deux paires de piliers **1** mais peut en comporter un plus grand nombre. Dans la configuration décrite, les paires de piliers **1** sont mises en opposition les unes par rapport aux autres. Cette configuration permet de réduire de moitié la déformation des piliers **1** tout en gardant le même effort. Bien que cette configuration soit privilégiée, le moteur piézoélectrique **30** peut comporter n'importe quelle quantité de piliers **1,** comme par exemple un assemblage comprenant entre 1 et 40 piliers.

Afin de produire de l'électricité, il est nécessaire d'appliquer une contrainte mécanique sur les céramiques piézoélectriques **2.** Pour produire cette contrainte, le moteur **30** est constitué d'un dispositif d'amplification mécanique **31, 32** permettant d'effectuer un écrasement des piliers **1.** Ce dispositif comprend:
- un moyen **31** permettant d'écraser chacun des piliers **1** et pouvant se présenter sous la forme de mâchoires ;
- un moyen **32** se présentant sous la forme d'un levier **301** et venant exercer un effort sur les deux mâchoires du système **31** de manière à les ouvrir pour écraser les piliers **1.** L'effet synergique des deux moyens **31, 32** permet une amplification de l'effort pouvant aller d'un facteur 10 à 1000.

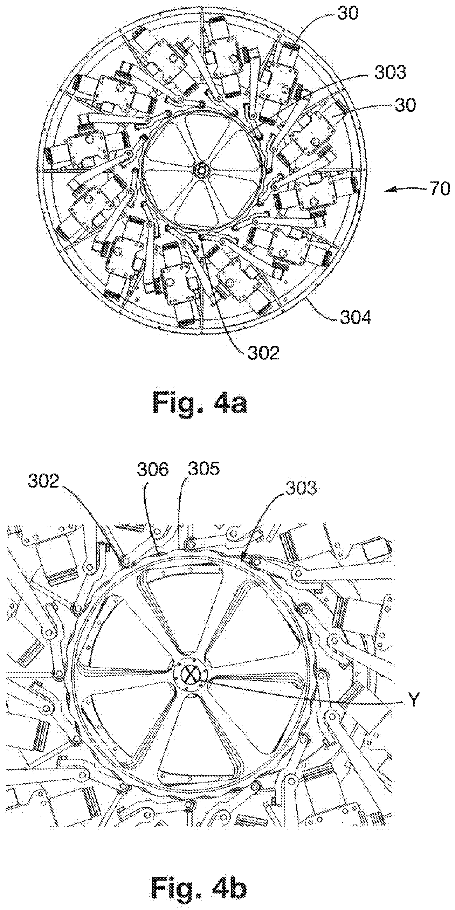

Pour obtenir l'écrasement des piliers 1, un effort est appliqué au bout du levier **301** du moyen **32.** Comme représenté sur la figure 4a, les moteurs **30** préférentiellement placés et fixés en étoile sur un support circulaire **304** de manière à former la couronne moteur **70.** Le levier **301** possède une extrémité distale et une extrémité proximale. L'extrémité distale du levier **301** comporte un galet **302** qui roule sur une came circulaire ondulée **303**. Le galet **302** est relié au levier **301** grâce à des moyens de fixation **401** pouvant se présenter sous la forme d'une articulation, d'une vis ou encore d'un système de boulons et d'écrous. Son extrémité proximale est reliée aux mâchoires du moyen **31** grâce à des moyens de fixation **402** lui permettant de transférer l'effort agissant sur le levier **301** aux auxdites mâchoires. Bien que cette configuration permettant un mouvement de rotation autour d'un axe x afin d'ouvrir les mâchoires et permettre que celles-ci écrasent les piliers **1** soit privilégiée, n'importe quel autre type de mouvement, comme par exemple un mouvement de translation, peut être envisagé en vue d'écraser les piliers **1.**

La came **303**, représentée sur les figures 4a et 4b, possède une alternance de bosses **305** et de creux **306.** Les bosses **305** forment des points de contact permettant, lors de la rotation de ladite came **303** et du passage des galets **302**, d'exercer un effort mécanique maximal sur le bras de levier **301.** Bien que ce mode de réalisation soit privilégié, les bosses **305** ainsi que les galets **302** peuvent être remplacés par des aimants de manière à permettre une transmission de l'effort sans contact.

Lors du placement des moteurs **30** sur le support circulaire **304**, un réglage du levier **301** permet d'obtenir un effort de contact maîtrisé lorsque le galet **302** se trouve dans le creux **306** présent entre deux bosses **305**. Ce réglage permet d'obtenir un effort radial équivalent pour chaque moteur **30** et d'assurer un contact mécanique entre les galets **302** et la came **303** au moment de leur passage dans les creux **306**. Les points de contact créés sont répartis de manière à minimiser les efforts tangentiels appliqués sur la came **303** et ainsi augmenter le nombre de moteurs **30** sans augmenter l'effort à fournir.

Préférentiellement, chaque couronne moteur **70** comporte N moteurs piézoélectriques **30,** et donc N galets **302** répartis de manière homogène sur la circonférence de la came **303**. Cette configuration permet de distribuer l'effort de façon à ce qu'il ne soit pas appliqué sur tous les galets **302** en même temps. En effet les galets **302** roulent sur la came **303** de manière à ce que pour un temps donné, certains galets se déplacent sur des bosses **305** pendant que les galets **302** opposés se déplacent dans des creux **306**. La came **303** comporte donc préférentiellement aN+1 bosses. Le nombre entier a, préférentiellement égal à deux, est choisi de manière à ce que le nombre de bosses **305** soit supérieur au nombre de piliers 1. Ainsi les efforts tangentiels exercés sur les moteurs piézoélectriques **30** se compensent au mieux pour réduire l'effort tangentiel résultant. Un nombre de bosses **305** différent peut toutefois être envisagé. On peut, par exemple, avoir un nombre de bosses **305** égal à un multiple du nombre de pilier **1.** Dans ce cas particulier, l'effort tangentiel résultant est égal à la somme des efforts tangentiels des moteurs piézoélectriques **30.**

Le nombre de bosses **305** permet également d'amplifier la fréquence de l'excitation primaire issue du flotteur **41** et provenant de la houle. En effet, pour chaque tour de came **303,** chacun des moteurs piézoélectrique **30** est excité aN+1 fois. Ainsi, alors que la fréquence de la houle peut seulement aller jusqu'à une vague toutes les 8 à 10 secondes, ce système permet d'obtenir un écrasement des piliers **1** ayant une fréquence pouvant aller jusqu'à 200 fois par seconde. Cette caractéristique permet ainsi d'augmenter la fréquence de l'effort appliqué pour écraser les piliers **1,** et donc d'augmenter le rendement de production d'énergie électrique des moteurs **30.**

La came **303** a un diamètre pouvant varier de 20 cm à 3 m, et est fabriquée dans un matériau rigide et résistant aux intempéries, comme par exemple en acier inoxydable, en aluminium ou encore une combinaison des deux.

Le nombre de moteurs **30** placés en étoile et fixés autour de la came **303** peut varier selon le rendement énergétique désiré pour l'appareil. La figure 4a montre une couronne moteur **70** ainsi formée et pouvant contenir entre 1 et 20 moteurs piézoélectriques **30.**

Comme le montre la figure 5, il est aussi possible d'empiler axialement plusieurs couronnes moteur **70** dont les cames **303** sont solidaires du même arbre de sortie **44.** Elles sont empilées suivant un axe y qui est l'axe de rotation des cames **303**. Ces couronnes **70** sont décalées les unes par rapport aux autres d'un angle égal à 2π(M(aN+1)), permettant ainsi de limiter l'effort tangentiel résultant en évitant d'appliquer un effort simultané sur toutes les bosses **305** (M étant le nombre de couronnes moteur **70** et N le nombre de galets **303**). Il est ainsi possible d'augmenter le rendement énergétique de l'appareil.

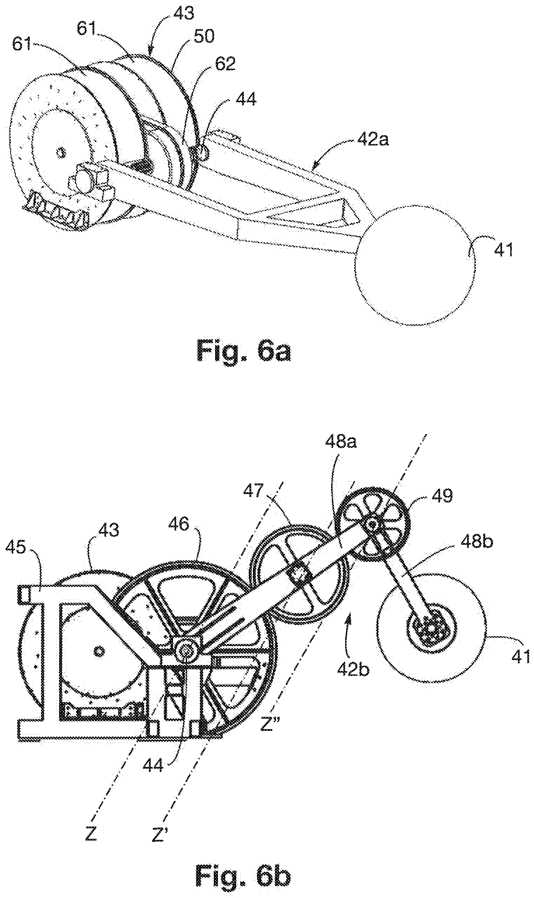

La contrainte mécanique appliquée sur les piliers **1** lors de leur écrasement, est produite grâce à l'effet de la houle sur l'appareil. Les figures 6a et 6b montrent des modes de réalisation d'appareils selon l'invention. Ils comprennent un élément flotteur **41** qui peut être sphérique, conique, cylindrique, ou encore toute autre forme convenant à l'Homme du métier. Ils peuvent être fabriqués dans n'importe quel matériau convenant à l'Homme du métier comme par exemple du bois, de l'aluminium, ou encore du polystyrène. Cet élément flotteur **41** est rattaché à un bras **42a, 42b** entrant en oscillation lorsque la houle met ledit élément flotteur **41** en mouvement. Ce bras **42a, 42b** relie l'élément flotteur **41** au générateur piézoélectrique **43** par l'intermédiaire d'un arbre d'entrée **44.** Lorsque le bras oscillant **42a, 42b** se met en mouvement, l'arbre d'entrée **44** effectue un mouvement de rotation qui est transmis au générateur piézoélectrique **43.**

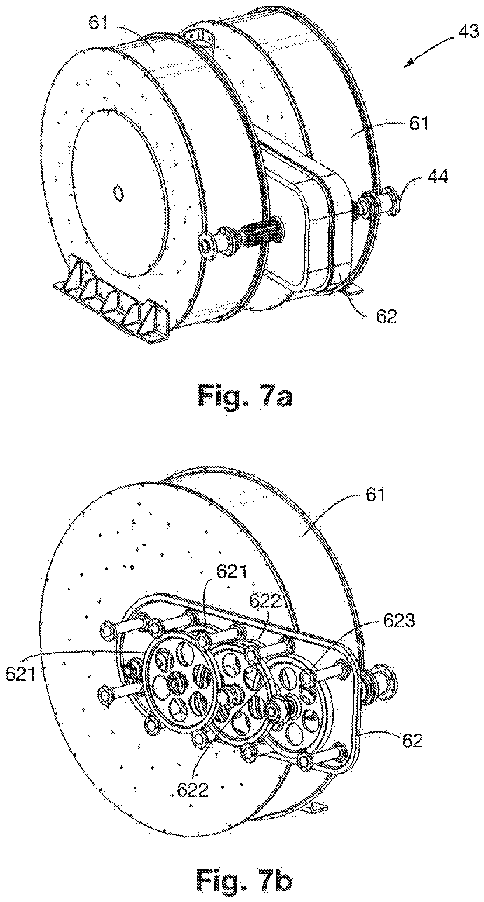

Le générateur piézoélectrique **43** est représenté sur la figure 7a. Il peut être installé sur un châssis **45** permettant ainsi de le fixer à une structure de référence telle qu'un bâti ou encore un flotteur à forte inertie. Il se compose de deux blocs **61** et d'un carter **62** contenant une boîte à pignon **63** (représentée de manière plus détaillée sur la figure 7b). Chacun des blocs **61** est constitué d'une (figure 4a) ou de plusieurs (figure 5) couronnes moteurs **70.**

Le rendement énergétique des piliers **1** est déterminé par la géométrie et le nombre de couronnes moteurs **70** ainsi que par les propriétés piézoélectriques du matériau. Afin d'augmenter ce rendement, une amplification de la fréquence de l'excitation primaire, à savoir l'excitation du flotteur **41** par la houle, peut être obtenue grâce à l'utilisation d'une boîte à pignon **62.** Celle-ci est placée entre l'arbre **44** des couronnes moteur **70** et le bras oscillant **42a, 42b.** Elle permet ainsi d'amplifier la vitesse de rotation de l'arbre **44** d'un facteur pouvant aller de 10 à 1000.

Dans le mode de réalisation de la figure 7a, deux blocs d'empilement **61** de couronnes moteurs **70** sont placés de part et d'autre d'une boîte à pignon **62.** Comme le montre la figure 7b, chaque empilement a son pignon de sortie, solidaire de l'arbre commun **44** et en prise avec une première roue dentée **621** qui est elle-même en prise avec une seconde roue dentée **622**. Ce dispositif est doublé pour chaque empilement **61.** Une troisième roue dentée **623**, commune aux deux empilements **61,** est en prise avec les secondes roues dentées **622,** et solidaire de l'arbre **44.** Cette boîte à pignon **62** permet ainsi une amplification de fréquence en augmentant la vitesse de rotation de l'arbre **44** et donc la vitesse angulaire des cames **303**.

Dans la configuration représentée sur la figure 6b, le bras **42b** est articulé et se décompose en deux parties reliées entre elles par des engrenages. En effet, le bras **42b** se compose de deux bras secondaires **48a, 48b** reliés entre eux par un moyen de fixation **490**, ce moyen **490** pouvant se présenter sous la forme d'une vis, d'système d'écrou et boulon ou encore tout autre moyen convenant à l'Homme du métier. Deux secteurs de roue dentée **46** sont fixés sur le châssis **45** et deux roues dentées intermédiaires **47** sont montées sur le bras principal **48a** de manière à être libres en rotation autour d'un axe z parallèle à l'arbre d'entrée **44.** Chacune de ces roues intermédiaires **47** étant en prise avec un secteur de roue dentée **46** en rotation autour d'un axe z' ainsi qu'avec une troisième roue dentée **49** en rotation autour d'un axe z" et solidaire du bras secondaire **48b.** L'autre extrémité du bras secondaire **48b** est rattachée au flotteur **41.** Cette configuration permet d'avoir un débattement angulaire plus important tout en conservant le même débattement angulaire pour le flotteur **41.** Ainsi la vitesse de rotation de l'arbre d'entrée **44** du générateur piézoélectrique **43** est augmentée et permet ainsi l'augmentation de la fréquence de l'excitation mécanique qui s'exerce sur les piliers **1.**

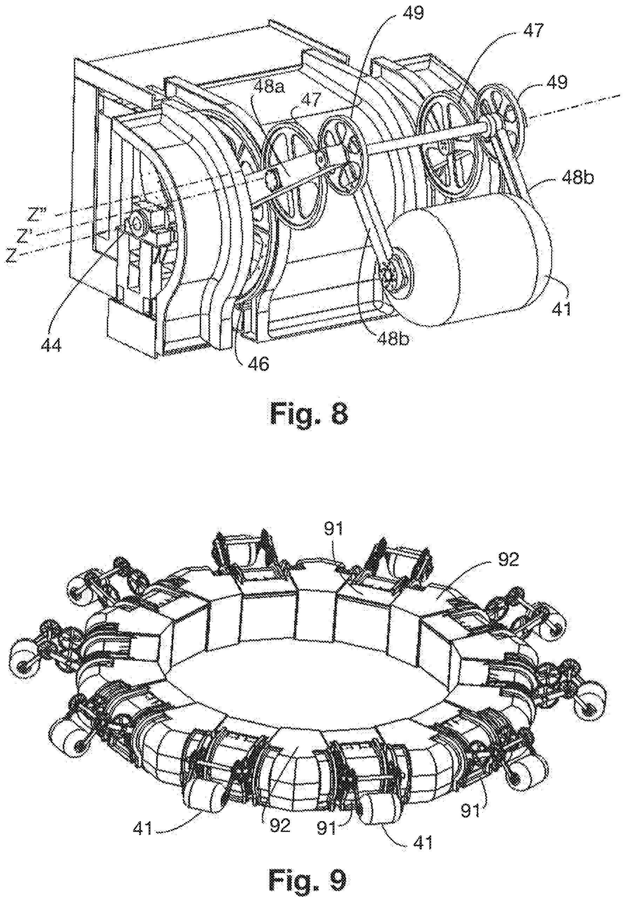

Sur la figure 8, les parties constituant le générateur piézoélectrique **43** ainsi que le châssis **45** sont carénées de façon à les protéger de la mer ou de toute autre agression de l'environnement, permettant ainsi d'obtenir un appareil pérenne et résistant aux intempéries. Le carénage est réalisé dans un matériau résistant à l'air ainsi qu'à l'eau comme par exemple en acier inoxydable, en aluminium ou encore en matériau composite.

Dans le système représenté sur la figure 9, plusieurs appareils selon l'invention sont assemblés les uns aux autres via une structure métallique **91** et des éléments flotteurs **92.** Cette structure **91** peut être circulaire, hexagonale, linéaire ou encore toute autre forme convenant à l'Homme du métier. Toutefois, l'utilisation de l'appareil ne se limite pas à ce type de structure **91.** Il peut, par exemple, être installé sur une structure tierce **91** bâtie ou flottante comme par exemple une digue, un quai, une barge, une plate-forme offshore, un bateau ou encore toute autre structure permettant un mouvement relatif entre elle et le flotteur. Celle-ci peut aussi être configurée de manière à pouvoir être ancrée sur le fond de la mer grâce, par exemple, à des moyens de fixation tels qu'un dispositif de chaînes, corps mort et amarres. Le nombre d'appareils installés sur une structure tierce **91** peut varier, et est compris entre 1 et 100.

Dans un mode de réalisation, la structure **91** est couplée à d'autres systèmes de production d'électricité en mer, tels que des éoliennes, des hydroliennes ou encore n'importe quel autre système houlomoteur. Ceci permet de bénéficier des infrastructures déjà présentes telles que les infrastructures d'ancrage, de stockage, de raccord au réseau, d'entretien, ou encore de maintenance.

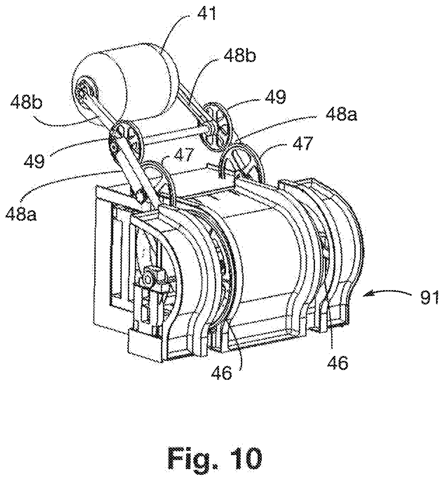

Dans le mode de réalisation de la figure 10, l'appareil est muni d'un moteur pouvant, par exemple, être hydraulique, électrique, ou encore à air comprimé. Ce moteur permet de rabattre et verrouiller les flotteurs 41 et leurs bras 42a, 42b en cas de tempête.

L'agencement des différents éléments et/ou moyens et/ou étapes de l'invention, dans les modes de réalisation décrits ci-dessus, ne doit pas être compris comme exigeant un tel agencement dans toutes les implémentations. En tout état de cause, on comprendra que diverses modifications peuvent être apportées à ces éléments et/ou moyens et/ou étapes, sans s'écarter de l'esprit et de la portée de l'invention. En particulier :
- le nombre de piliers **1** utilisés peut varier,
- le type de matériau utilisé pour les électrodes **3** peut être différent,
- le nombre de céramiques **2** utilisées dans chaque pilier **1** peut varier d'un appareil à un autre,
- les éléments de maintien **5** peuvent être de différentes sortes,
- le circuit **8** composant le système d'extraction de charge peut être différent d'un appareil à un autre,
- l'appareil peut contenir ou non un système de stockage temporaire **13,**
- le matériau utilisé pour le flotteur **41** peut être varié,
- les systèmes d'amplification mécanique **31, 32** peuvent être différents d'un appareil à un autre,
- le nombre de bosses **305** présentes sur la came **303** peut varier,
- le nombre de moteurs **30** par couronne moteur **70** peut varier,
- le nombre de couronnes moteur **70** par générateur piézoélectrique **43** peut varier,
- le type de bras **42a, 42b** peut être différent d'un appareil à un autre,
- le type de structure tierce **91** sur laquelle est (sont) installé(s) le(s) appareil(s) peut varier,
- le nombre d'appareils installés sur la structure tierce **91** est variable,
- le bras articulé **42b** peut être utilisé dans des appareils ayant d'autres applications que celle décrite dans le document,
- le système permettant d'augmenter la fréquence d'écrasement des piliers 1 peut être utilisé dans n'importe quel appareil, quelle que soit son utilisation, comme par exemple dans des appareils installés dans des systèmes électromagnétiques, hydrauliques ou encore mécaniques,
- la came **303** peut être remplacée par une crémaillère ondulée,
- la came **303** peut être utilisée avec d'autre type de moteur qui ne sont pas piézoélectriques, comme par exemple dans des systèmes électromagnétiques, hydrauliques ou encore mécaniques,
- le bras **42a, 42b** peut être utilisé pour actionner d'autres types de moteurs, comme par exemple des moteurs présents dans des systèmes électromagnétiques, hydrauliques ou encore mécaniques.

## Revendications

1. Appareil pour convertir une énergie de houle en énergie électrique comprenant :
- un élément flotteur (41) excité à une fréquence définie par la houle,
- un système d'extraction de puissance (43) coopérant avec l'élément flotteur (41) pour convertir une énergie mécanique en une énergie électrique, ladite énergie mécanique provenant du déplacement de l'élément flotteur (41) excité par ladite houle,
**caractérisé en ce que** ledit système d'extraction de puissance (43) se présente sous la forme d'un amplificateur de fréquence se composant :
- d'au moins deux moteurs piézoélectriques (30) chacun composé d'au moins un pilier piézoélectrique (1) excité à une fréquence supérieure à celle dudit flotteur (41),
- d'un organe (50) pour activer lesdits moteurs piézoélectriques (30), lequel organe (50) agit sur les moteurs piézoélectriques (30) de manière à écraser lesdits piliers piézoélectriques (1),
chaque moteur piézoélectrique (30) comprenant un dispositif d'amplification mécanique, lequel dispositif est relié à des galets (302) et comporte :
a) des mâchoires (31) qui, lorsqu'elles sont sollicitées, appliquent une contrainte mécanique sur les piliers (1),
b) un levier (32) agissant sur les mâchoires (31) de manière à les solliciter, lequel levier (32) comporte une extrémité proximale rattachée auxdites mâchoires (31) et une extrémité distale rattachée à un galet (302), ledit galet (302) étant en contact avec l'organe (50) de manière à activer ledit moteur piézoélectrique (30),
**et en ce que** ledit système d'extraction de puissance (43) comporte un bras oscillant (42a, 42b) composé d'une première extrémité rattachée audit organe (50) et d'une deuxième extrémité rattachée audit flotteur (41), de manière à ce que ledit bras (42a, 42b) transfère l'énergie mécanique provenant du déplacement dudit flotteur (41) audit organe (50).

2. Appareil selon la revendication 1, **caractérisé en ce que** le système d'extraction de puissance (43) se compose d'une couronne moteur (70), laquelle couronne moteur (70) comporte plusieurs moteurs (30) adjacents placés et fixés en étoile sur un support circulaire (304), lesquels moteurs (30) sont placés de sorte que les galets (302) situés sur l'extrémité distale de leurs leviers (32), soient en contact avec l'organe (50), lesdits galets (302) coopérant avec ledit organe (50) de manière à transférer leur énergie mécanique audit levier (32).

3. Appareil selon la revendication 2, **caractérisé en ce que** l'organe (50) se présente sous la forme d'une came circulaire ondulée (303) sur laquelle les galets (302) se déplacent.

4. Appareil selon la revendication 3, **caractérisé en ce que** la came circulaire ondulée (303) comporte 2N+1 bosses, avec N étant égal au nombre de moteurs (30).

5. Appareil selon l'une des revendications 2 à 4, **caractérisé en ce que** le système d'extraction de puissance (43) se compose de plusieurs couronnes moteur (70) alignées axialement les unes par rapport aux autres.

6. Appareil selon la revendication 5, **caractérisé en ce que** les couronnes moteur (70) sont installées de manière à ce que chacune de leurs cames (303) soit décalée angulairement.

7. Appareil selon l'une des revendications 3 à 6, **caractérisé en ce qu'**une boîte à pignons (63) est placée entre l'organe (50) et le bras oscillant (42a, 42b) de manière à augmenter la vitesse de rotation de la came (303).

8. Appareil selon l'une des revendications 1 à 7, **caractérisé en ce que** le pilier (1) est composé d'une alternance de céramiques piézoélectriques (2) et d'électrodes (3) empilées axialement.

9. Appareil selon l'une des revendications 1 à 8, **caractérisé en ce que** le pilier (1) est raccordé à un circuit électronique (8), lequel circuit (8) est adapté pour augmenter la quantité d'énergie électrique produite par ledit pilier (1).

10. Appareil selon l'une des revendications 1 à 9, **caractérisé en ce que** le bras oscillant (42b) est un bras articulé.

11. Appareil selon l'une des revendications 1 à 10, **caractérisé en ce qu'**il comporte une interface mécanique de fixation lui permettant de se fixer à une structure tierce (91).

12. Installation pour convertir l'énergie de la houle en énergie électrique **caractérisée en ce qu'**elle est composée de plusieurs appareils selon l'une des revendications précédentes, lesquels appareils sont installés sur une structure tierce (91).

13. Installation selon la revendication 12, **caractérisée en ce que** la structure tierce (91) est une structure flottante.

14. Installation selon la revendication 12, **caractérisée en ce que** la structure (91) est une structure immergée installée sur un fond marin.

## Patentansprüche

1. Vorrichtung zum Umwandeln einer Wellenenergie in elektrische Energie, umfassend:
- ein Schwimmelement (41), das mit einer Frequenz angeregt wird, die von den Wellen definiert wird,
- ein System zur Entnahme von Leistung (43), das mit dem Schwimmelement (41) zusammenwirkt, um eine mechanische Energie in eine elektrische Energie umzuwandeln, wobei die mechanische Energie aus der Bewegung des Schwimmelements (41) hervorgeht, das von den Wellen angeregt wird,
**dadurch gekennzeichnet, dass** das System zur Entnahme von Leistung (43) in Form eines Frequenzverstärkers vorliegt, der aus Folgendem besteht:
- mindestens zwei piezoelektrischen Motoren (30), die jeweils von mindestens einem piezoelektrischen Pfeiler (1) gebildet sind, der mit einer Frequenz angeregt wird, die größer als die des Schwimmers (41) ist,
- einem Element (50) zum Aktivieren der piezoelektrischen Motoren (30), wobei das Element (50) auf die piezoelektrischen Motoren (30) wirkt, um die piezoelektrischen Pfeiler (1) zusammenzudrücken,
jeder piezoelektrische Motor (30) umfassend eine Vorrichtung zur mechanischen Verstärkung, wobei die Vorrichtung mit Rollen (302) verbunden ist und Folgendes aufweist:
a) Backen (31), die, wenn sie beansprucht werden, eine mechanische Spannung auf die Pfeiler (1) ausüben,
b) einen Hebel (32), der auf die Backen (31) wirkt, um sie zu beanspruchen, wobei der Hebel (32) ein proximales Ende aufweist, das mit den Backen (31) in Verbindung steht, und ein distales Ende, das mit einer Rolle (302) in Verbindung steht, wobei die Rolle (302) mit dem Element (50) in Kontakt steht, um den piezoelektrischen Motor (30) zu aktivieren,
und dadurch, dass das System zur Entnahme von Leistung (43) einen Schwingarm (42a, 42b) aufweist, der von einem ersten Ende, das mit dem Organ (50) in Verbindung steht, und einem zweiten Ende, das mit dem Schwimmer (41) in Verbindung steht, gebildet ist, so dass der Arm (42a, 42b) die mechanische Energie, die aus der Bewegung des Schwimmers (41) hervorgeht, auf das Element (50) überträgt.

2. Vorrichtung nach Anspruch 1, **dadurch gekennzeichnet, dass** das System zur Entnahme von Leistung (43) aus einem Motorkranz (70) besteht, wobei der Motorkranz (70) mehrere benachbarte Motoren (30) aufweist, die sternförmig auf einem kreisförmigen Träger (304) platziert und angebracht sind, wobei die Motoren (30) derart platziert sind, dass die Rollen (302), die an dem distalen Ende ihrer Hebel (32) gelegen sind, mit dem Element (50) in Kontakt stehen, wobei die Rollen (302) mit dem Element (50) zusammenwirken, um ihre mechanische Energie auf den Hebel (32) zu übertragen.

3. Vorrichtung nach Anspruch 2, **dadurch gekennzeichnet, dass** das Element (50) in Form eines gewellten kreisförmigen Nockens (303) vorliegt, auf dem sich die Rollen (302) bewegen.

4. Vorrichtung nach Anspruch 3, **dadurch gekennzeichnet, dass** der gewellte kreisförmige Nocken (303) 2N+1 Wölbungen aufweist, wobei N gleich der Anzahl von Motoren (30) ist.

5. Vorrichtung nach einem der Ansprüche 2 bis 4, **dadurch gekennzeichnet, dass** das System zur Entnahme von Leistung (43) aus mehreren Motorkränzen (70) besteht, die axial zueinander ausgerichtet sind.

6. Vorrichtung nach Anspruch 5, **dadurch gekennzeichnet, dass** die Motorkränze (70) derart montiert sind, dass jeder ihrer Nocken (303) in einem Winkel versetzt ist.

7. Vorrichtung nach einem der Ansprüche 3 bis 6, **dadurch gekennzeichnet, dass** ein Zahnradgetriebe (63) zwischen dem Element (50) und dem Schwingarm (42a, 42b) platziert ist, um die Drehgeschwindigkeit des Nockens (303) zu erhöhen.

8. Vorrichtung nach einem der Ansprüche 1 bis 7, **dadurch gekennzeichnet, dass** der Pfeiler (1) von einem Wechsel von piezoelektrischen Keramiken (2) und Elektroden (3) gebildet ist, die axial gestapelt sind.

9. Vorrichtung nach einem der Ansprüche 1 bis 8, **dadurch gekennzeichnet, dass** der Pfeiler (1) an eine elektronische Schaltung (8) angeschlossen ist, wobei die Schaltung (8) angepasst ist, die Menge elektrischer Energie, die von dem Pfeiler (1) gebildet wird, zu erhöhen.

10. Vorrichtung nach einem der Ansprüche 1 bis 9, **dadurch gekennzeichnet, dass** der Schwingarm (42b) ein Gelenkarm ist.

11. Vorrichtung nach einem der Ansprüche 1 bis 10, **dadurch gekennzeichnet, dass** sie eine mechanische Befestigungsschnittstelle aufweist, die es ihr erlaubt, an einer Drittstruktur (91) befestigt zu werden.

12. Anlage zur Umwandlung der Wellenenergie in elektrische Energie, **dadurch gekennzeichnet, dass** sie aus mehreren Vorrichtungen nach einem der vorhergehenden Ansprüche besteht, wobei die Vorrichtungen auf einer Drittstruktur (91) montiert sind.

13. Anlage nach Anspruch 12, **dadurch gekennzeichnet, dass** die Drittstruktur (91) eine schwimmende Struktur ist.

14. Anlage nach Anspruch 12, **dadurch gekennzeichnet, dass** die Struktur (91) eine Unterwasserstruktur ist, die auf einem Meeresboden montiert ist.

## Claims

1. Apparatus for converting sea swell energy into electrical energy comprising:
- a float element (41) excited at a frequency defined by the swell,
- a power extraction system (43) co-operating with the float element (41) to convert a mechanical energy into an electrical energy, said mechanical energy originating from the displacement of the float element (41) excited by said swell,
**characterized in that** said power extraction system (43) takes the form of a frequency amplifier composed of:
- at least two piezoelectric motors (30) each composed of at least one piezoelectric pillar (1) excited at a frequency higher than that of said float (41),
- a member (50) for activating said piezoelectric motors (30), which member (50) acts on the piezoelectric motors (30) so as to compress said piezoelectric pillars (1),
each piezoelectric motor (30) comprising a mechanical amplification device, which device is linked to rollers (302) and comprises:
a)jaws (31) which, when they are stressed, apply a mechanical strain on the pillars (1),
b)a lever (32) acting on the jaws (31) so as to stress them, which lever (32) comprises a proximal end attached to said jaws (31) and a distal end attached to a roller (302), said roller (302) being in contact with the member (50) so as to activate said piezoelectric motor (30),
**and in that** said power extraction system (43) comprises an oscillating arm (42a, 42b), composed of a first end attached to said member (50) and of a second end attached to said float (41), such that said arm (42a, 42b) transfers the mechanical energy originating from the displacement of said float (41) to said member (50) .

2. Apparatus according to Claim 1, **characterized in that** the power extraction system (43) is composed of a motor crown ring (70), which motor crown ring (70) comprises several adjacent motors (30) placed and fixed in star configuration on a circular support (304), which motors (30) are placed in such a way that the rollers (302) situated on the distal end of their levers (32), are in contact with the member (50), said rollers (302) co-operating with said member (50) so as to transfer their mechanical energy to said lever (32).

3. Apparatus according to Claim 2, **characterized in that** the member (50) takes the form of a corrugated circular cam (303) over which the rollers (302) are displaced.

4. Apparatus according to Claim 3, **characterized in that** the corrugated circular cam (303) comprises 2N+1 ridges, with N being equal to the number of motors (30) .

5. Apparatus according to one of Claims 2 to 4, **characterized in that** the power extraction system (43) is composed of several motor crown rings (70) aligned axially relative to one another.

6. Apparatus according to Claim 5, **characterized in that** the motor crown rings (70) are installed in such a way that each of their cams (303) is angularly offset.

7. Apparatus according to one of Claims 3 to 6, **characterized in that** a gearbox (63) is placed between the member (50) and the oscillating arm (42a, 42b) so as to increase the speed of rotation of the cam (303).

8. Apparatus according to one of Claims 1 to 7, **characterized in that** the pillar (1) is composed of an alternation of piezoelectric ceramics (2) and of electrodes (3) stacked axially.

9. Apparatus according to one of Claims 1 to 8, **characterized in that** the pillar (1) is connected to an electronic circuit (8), which circuit (8) is adapted to increase the quantity of electrical energy produced by said pillar (1).

10. Apparatus according to one of Claims 1 to 9, **characterized in that** the oscillating arm (42b) is an articulated arm.

11. Apparatus according to one of Claims 1 to 10, **characterized in that** it comprises a mechanical fixing interface allowing it to be fixed to a third-party structure (91).

12. Installation for converting sea swell energy into electrical energy, **characterized in that** it is composed of several apparatuses according to one of the preceding claims, which apparatuses are installed on a third-party structure (91).

13. Installation according to Claim 12, **characterized in that** the third-party structure (91) is a floating structure.

14. Installation according to Claim 12, **characterized in that** the structure (91) is a submerged structure installed on a sea bed.
